# FASCICULE DE BREVET EUROPEEN

(11) **EP 1 936 667 B1**
(45) Date de publication et mention de la délivrance du brevet: **17.02.2010**
(21) Numéro de dépôt: 07024512.1
(22) Date de dépôt: 18.12.2007
(51) Int. Cl.: H01L 21/20, H01L 21/762

(54) **Traitement double plasma pour l'obtention d'une structure disposant d'un oxyde enterré ultra-fin**
Doppelplasmabehandlung zur Herstellung einer Struktur mit einem vergrabenen ultradünnen Oxid
Double plasma processing for achieving a structure having an ultra thin buried oxyde

(30) Priorité: 18.12.2006 FR 0655608
(43) Date de publication de la demande: 25.06.2008
(73) Titulaire: S.O.I.Tec Silicon on Insulator Technologies, 38190 Bernin (FR)
(72) Inventeur: Radu, Ionut, 38920 Crolle (FR); Lambert, Audrey, 38000 Grenoble (FR)
(74) Mandataire: Collin, Jérôme

(56) Documents cités:
- US-A1- 2005 067 377
- US-A1- 2006 118 870
- US-A1- 2006 121 691
- BENOIT OLBRECHTS ET AL: "Effect of interfacial SiO2 thickness for low temperature O2 plasma activated wafer bonding" MICROSYSTEM TECHNOLOGIES ; MICRO AND NANOSYSTEMS INFORMATION STORAGE AND PROCESSING SYSTEMS, SPRINGER-VERLAG, BE, vol. 12, no. 5, 1 avril 2006 (2006-04-01), pages 383-390, XP019349562 ISSN: 1432-1858
- DRAGOI V., FARRENS S. ET AL.: "Low temperature MEMS manufacturing processes: plasma activated wafer bonding" MICRO- AND NANOSYSTEMS- MATERIALS AND DEVICES. SYMPOSIUM (MATERIALS RESEARCH SOCIETY SYMPOSIUM PROCEEDINGS, vol. 872, 2005, pages 85-90, XP008080174
- SUNI T ET AL: "EFFECTS OF PLASMA ACTIVATION ON HYDROPHOLIC BONDING OF SI AND SIO2" JOURNAL OF THE ELECTROCHEMICAL SOCIETY, ELECTROCHEMICAL SOCIETY. MANCHESTER, NEW HAMPSHIRE, US, vol. 149, no. 6, juin 2002 (2002-06), pages G348-G351, XP008046162 ISSN: 0013-4651

## Description

### DOMAINE TECHNIQUE DE L'INVENTION

La présente invention concerne un procédé de collage de deux substrats réalisés dans des matériaux choisis parmi les matériaux semi-conducteurs, ledit procédé mettant en oeuvre :
- une étape de collage des deux substrats par traitement thermique,
- une activation plasma de la surface à coller de chaque substrat, la surface à coller d'un premier des deux substrats étant constituée d'une couche d'oxyde.

On connaît déjà des procédés de ce type.

Le « collage » est ici compris comme un collage par adhésion moléculaire, au cours duquel deux surfaces parfaitement planes adhèrent l'une à l'autre sans application de colle - ceci étant possible à température ambiante.

La qualité du collage est caractérisée notamment par l'énergie de collage, qui traduit la force de la liaison entre deux substrats collés ensemble.

Pour consolider un collage par adhésion moléculaire de deux substrats, on fait subir aux substrats assemblés un traitement thermique. Un tel traitement thermique permet d'amener l'énergie de collage de deux substrats à une valeur de l'ordre de 500mJ/m² au moins, ce qui peut correspondre aux valeurs typiquement désirées.

De manière classique, un tel traitement thermique est généralement mené à une température de l'ordre de 900°C au moins (ce qui définit dans le cadre de ce texte le domaine des « hautes températures »). Dans le cas d'un collage entre un substrat de Si et un substrat de Si ou de SiO₂, l'énergie de collage est maximisée avec un traitement mené à des températures de l'ordre de 1100-1200°C.

L' « activation plasma » d'une surface à coller est définie comme l'exposition de cette surface à un plasma (ceci pouvant se faire notamment sous vide ou à pression atmosphérique) préalablement à la mise en contact des surfaces à coller.

Plus précisément, dans les techniques connues d'activation la surface d'un substrat à activer est exposée à un plasma lors d'une étape d'exposition dans laquelle les paramètres d'exposition sont contrôlés pour être chacun fixé à une valeur respective donnée, qui reste fixe durant l'activation plasma.

En premier ordre, les « paramètres d'exposition » sont :
- la densité de puissance. II s'agit de la densité de puissance alimentant le plasma, qui traduit une densité de puissance par unité de surface (W/cm²) et qui pourra également être désignée sous le simple terme de « puissance » dans ce texte,
- la pression (pression dans l'enceinte contenant le plasma, exprimée en mTorr),
- la nature et le débit du gaz (exprimé en sccm : standard cubic centimeter per minute, pour centimètre cube standard par minute) alimentant cette enceinte.

Une telle activation permet notamment de réaliser des collages par adhésion moléculaire, en obtenant des énergies de collage importantes sans nécessiter le recours à un traitement thermique faisant intervenir des hautes températures.

L'activation plasma permet en effet d'obtenir, entre deux substrats dont un au moins a été activé avant collage, des fortes énergies de collage après des traitements thermiques menés sur des durées relativement courtes (par exemple de l'ordre de 2 heures) et à des températures relativement basses (par exemple de l'ordre de 600°C ou moins).

Une telle activation est donc avantageuse pour stabiliser une structure comprenant deux substrats collés, dans le cas où on désire éviter de soumettre la structure à des températures trop importantes (notamment le cas des hétérostructures, qui sont définies comme des structures comportant des couches réalisées en des matériaux ayant des coefficients de dilatation thermique sensiblement différents).

Une telle activation peut également être intéressante pour obtenir des forces de collage importantes à température donnée.

Une telle activation est ainsi intéressante par exemple pour réaliser des structures multicouches en faisant intervenir un collage de deux substrats.

Les procédés de transfert (notamment les procédés de type Smart Cut™ dont on peut trouver une description générale dans l'ouvrage SILICON-ON-INSULATOR TECHNOLOGY: Materials to VLSI, 2nd Edition (Jean-Pierre COLINGE),ou des procédés de type BESOI (Bond Etch Silicon On Insulator) dans lequel on colle deux substrats puis on élimine par gravure le surplus de matière d'un des substrats) constituent des exemples d'application pouvant bénéficier d'une activation plasma en support d'un collage.

Pour profiter pleinement des effets du traitement plasma pour chaque collage, le procédé classique rencontré dans la littérature (notamment dans les documents Effects of plasma activation on hydrophilic bonding of Si and SiO2, T. Suni et I. J. Electroch. Soc. Vol. 149, n°6, p.348 (2002) et dans le brevet américain US 6 645 828 de Farrens et al.) consiste à activer par plasma les deux substrats à coller.

Le document US 2005/067377 concerne des procédés de formation d'une structure du type GOI (et structures similaires) comprenant notamment une étape de collage de deux couches avec une activation préalable par plasma sous atmosphère oxygène.

Plus rarement, une seule des deux surfaces est exposée au plasma car l'énergie de collage est faible. Dans le cas d'un collage Si/SiO₂, c'est alors généralement l'oxyde qui est traité par plasma (voir Effects of plasma activation on hydrophilic bonding of Si and SiO₂).

Différents gaz sont aujourd'hui utilisés dans les traitements plasma pour activer les surfaces des plaques avant leur mise en contact, comme par exemple l'oxygène, l'azote et l'argon.

D'une façon générale, les deux surfaces à coller sont traitées de la même manière avec le même traitement plasma.

Le but de l'invention est d'améliorer les techniques connues de collage mettant en oeuvre une activation plasma.

Un autre but de l'invention est de diminuer le nombre de défauts présents sur un substrat, voire même d'éliminer complètement ces défauts.

En particulier, un but de l'invention est d'augmenter l'énergie de collage obtenu après activation plasma.

Afin d'atteindre ces buts, l'invention propose selon un premier aspect un procédé de collage de deux substrats réalisés dans des matériaux choisis parmi les matériaux semi-conducteurs, ledit procédé mettant en oeuvre :
- une étape de collage des deux substrats par traitement thermique,
- une activation plasma de la surface à coller de chaque substrat, la surface à coller de seulement un premier des deux substrats étant constituée d'une couche d'oxyde,
procédé caractérisé en ce que l'activation plasma de ladite couche d'oxyde est réalisée sous une atmosphère contenant de l'oxygène, et l'activation plasma de la surface à coller du deuxième substrat est réalisée sous une atmosphère inerte.

Des aspects préférés mais non limitatifs de ce procédé sont les suivants :
- le substrat dont la surface est constituée d'une couche d'oxyde est le substrat donneur pour un transfert de couche vers un substrat receveur,
- la couche d'oxyde est obtenue par oxydation par voie thermique du substrat donneur,
- la couche d'oxyde est déposée sur le substrat donneur,
- le transfert permet d'obtenir une structure de type SOI (Siicon On Insulator, c'est-à-dire silicium sur isolant),
- ledit SOI comporte une couche mince de type « couche très fine enterrée » UTBOX (Ultra Thin Buried oxyde), dont l'épaisseur est inférieure à 500 Å,
- le substrat receveur est en silicium,
- le gaz neutre est de l'argon,
- la densité de puissance lors de l'activation par un plasma sous une atmosphère comprenant de l'argon est de 0.4 W/ cm²,
- le gaz neutre est de l'azote,
- la densité de puissance lors de l'activation par un plasma sous une atmosphère comprenant de l'azote est de 0.8 W/ cm²,
- le substrat receveur est soumis à une étape de nettoyage avant l'étape d'activation par plasma,
- le substrat donneur est soumis à une étape de nettoyage avant l'étape d'activation par plasma,
- le traitement thermique de collage est effectué à basse température,
- le traitement thermique de collage est effectué ente 200°C et 600°C,
- le traitement thermique de collage est effectué sur une durée courte,
- le traitement thermique de collage est effectué pendant environ 2 heures.

Est également présentée une structure de type SOI obtenue par le transfert sur un substrat receveur d'une couche mince prélevée sur un substrat donneur, suite à un collage par activation plasma selon un procédé du type mentionné ci-dessus, caractérisée en ce qu'elle a une couche enterrée d'oxyde de type « couche très fine enterrée » UTBOX (Ultra Thin Buried Oxyde).

Des aspects préférés de cette structure sont les suivants :
- l'épaisseur de la couche d'oxyde enterrée est comprise entre 50 et 1000 Å, préférentiellement inférieure à 500 Å,
- pour une épaisseur de la couche d'oxyde enterrée d'environ 250 Å, elle a entre 0 et 10 défauts,
- pour une épaisseur de la couche d'oxyde enterrée d'environ 125 Å. elle a entre 0 et 310 défauts,
- pour une épaisseur de la couche d'oxyde enterrée d'environ 1000 Å, et pour une activation plasma sous une atmosphère neutre réalisée avec de l'argon, son énergie de collage à température ambiante est d'environ 0.175 J/m²,
- pour une épaisseur de la couche d'oxyde enterrée d'environ 500 Å, et pour une activation plasma sous une atmosphère neutre réalisée avec de l'argon, son énergie de collage à température ambiante est d'environ 0.180 J/m²,
- pour une épaisseur de la couche d'oxyde enterrée d'environ 250 Å, et pour une activation plasma sous une atmosphère neutre réalisée avec de l'argon, son énergie de collage à température ambiante est d'environ 0.200 J/m².
- pour une épaisseur de la couche d'oxyde enterrée d'environ 125 Å, et pour une activation plasma sous une atmosphère neutre réalisée avec de l'argon, son énergie de collage à température ambiante est d'environ 0.200 J/m²,
- pour une épaisseur de la couche d'oxyde enterrée d'environ 1000 Å, et pour une activation plasma sous une atmosphère neutre réalisée avec de l'azote, son énergie de collage à température ambiante est d'environ 0.235 J/m²,
- pour une épaisseur de la couche d'oxyde enterrée d'environ 500 Å, et pour une activation plasma sous une atmosphère neutre réalisée avec de l'azote, son énergie de collage à température ambiante est d'environ 0.0.258 J/m²,
- pour une épaisseur de la couche d'oxyde enterrée d'environ 250 Å, et pour une activation plasma sous une atmosphère neutre réalisée avec de l'azote, son énergie de collage à température ambiante est d'environ 0.270 J/m²,
- pour une épaisseur de la couche d'oxyde enterrée d'environ 125 Å, et pour une activation plasma sous une atmosphère neutre réalisée avec de l'azote, son énergie de collage à température ambiante est d'environ 0.262 J/m².

Le procédé de collage selon l'invention peut être mis en oeuvre dans la perspective du transfert d'une couche mince en vue de fabriquer des substrats de type SOI (Silicon On Insulator c'est-à-dire silicium sur isolant), réalisés par collage par adhésion moléculaire avec la mise en oeuvre d'un transfert de couche (par exemple par une méthode de transfert de type Smart Cut™ ou autre).

Plus précisément, une application avantageuse de l'invention concerne la fabrication de substrats SOI comportant des couches isolantes très fines de type UTBOX (Ultra Thin Buried oxyde), dont l'épaisseur est inférieure à 500 Angström, par exemple de l'ordre de la centaine d'Angström. Un exemple particulier mais non limitatif de l'invention qui est décrit concerne ainsi des substrats de type UTBOX pour lesquels de bons résultats ont été obtenus. On précise toutefois que l'invention s'applique également à des BOX (Buried Oxide) épais, c'est-à-dire d'une épaisseur supérieure à 500 Å.

En effet, lorsque la couche d'oxyde enterrée de telles structures est très fine, on peut observer des problèmes de défectivité (zones non transférées, picots, bulles et cloques) au sein de la couche transférée.

L'invention s'applique de manière générale au collage de deux substrats de matériau semi-conducteur. Chacun de ces matériaux peut être du silicium, ou un autre matériau semi-conducteur.

L'une des surfaces à coller des deux substrats est en outre oxydée préalablement à l'activation.

Comme on va le voir, une activation est réalisée sur chacune des deux surfaces à coller.

On précise également que l'invention permet de réaliser un collage notamment dans le cadre d'une méthode de transfert d'une couche mince de matériau semi-conducteur, d'une plaque « top » formant substrat donneur vers une plaque « base » formant substrat receveur. Par couche mince, on entend une couche de quelques centaines à quelques milliers d'angströms d'épaisseur.

Dans cette application aux méthodes de transfert, le collage est réalisé après l'activation, entre une surface dudit substrat donneur et une surface dudit substrat receveur.

Ledit procédé de transfert peut notamment être réalisé selon la méthode Smart Cut™ mettant en oeuvre une implantation de fragilisation avant le collage pour créer dans l'épaisseur du substrat donneur une zone de fragilisation, et un détachement au niveau de ladite zone de fragilisation après le collage.

L'invention sera mieux comprise à la lecture de la description détaillée suivante, faite en référence aux dessins annexés sur lesquels :

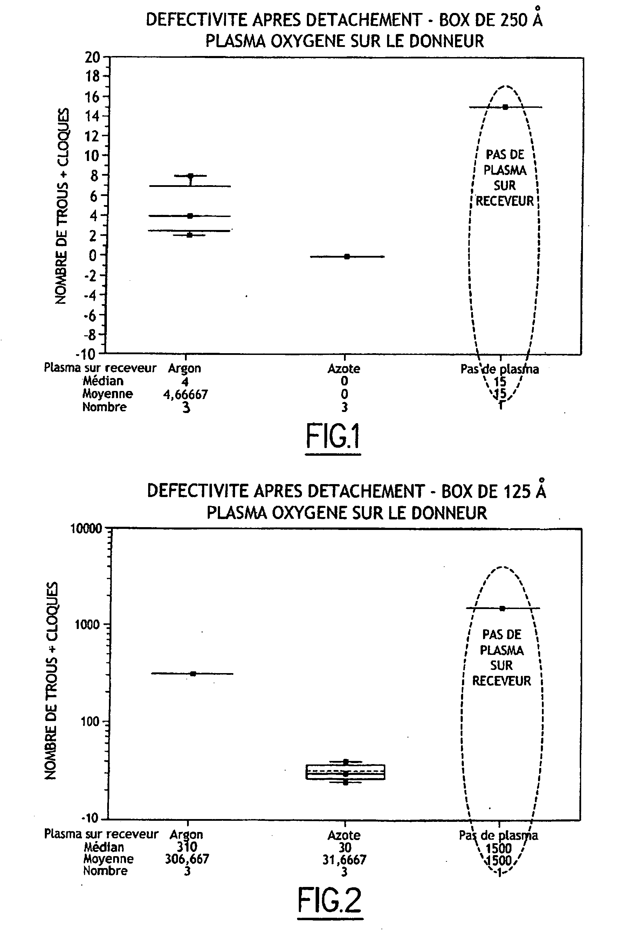

- La figure 1 est un graphe qui compare le nombre de défauts dénombrés après détachement dans le cadre d'un transfert d'une couche issue d'un substrat donneur collé avec un substrat receveur pour une couche d'oxyde de 250 Å, le collage ayant été réalisé à l'issue d'une activation plasma lors duquel :
   - le substrat donneur, oxydé en surface, a été activé par un plasma oxydant,
   - et le substrat receveur en silicium, a été activé par l'un de deux types de plasma sous une atmosphère constituée d'un gaz inerte (azote ou argon), ou n'a pas été activé.
- La figure 2 est un graphe qui compare le nombre de défauts dénombrés après détachement dans le cadre d'un transfert d'une couche issue d'un substrat donneur collé avec un substrat receveur pour une couche d'oxyde de 125 Å, le collage ayant été réalisé à l'issue d'une activation plasma lors duquel :
   - le substrat donneur, oxydé en surface, a été activé par un plasma oxydant,
   - et le substrat receveur en silicium, a été activé par l'un de deux types de plasma sous une atmosphère constituée d'un gaz inerte (azote ou argon), ou n'a pas été activé.

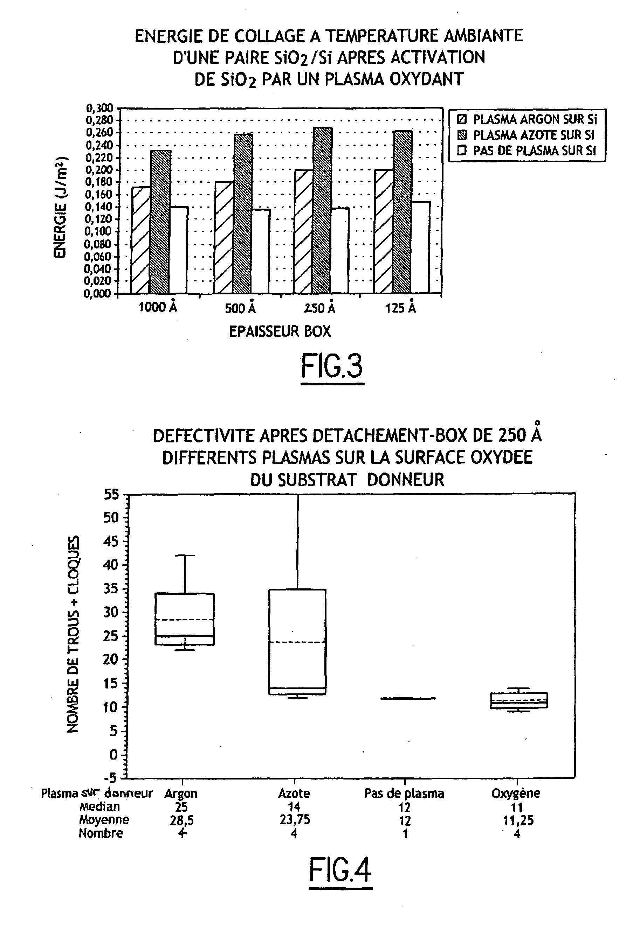

- La figure 3 compare les énergies de collage obtenues entre deux substrats collés ensemble, l'un des substrats étant recouvert d'une couche d'oxyde et ayant été activé avant collage par un plasma oxydant, et ce pour :
   - différents types de préparation du substrat non oxydé (activation par un plasma d'azote ou d'argon, et sans activation plasma)
   - différentes épaisseurs de la couche d'oxyde recouvrant le substrat oxydé en surface (1000 Å, 500 Å, 250 Å et 125 Å).
- La figure 4 est un graphe qui compare le nombre de défauts dénombrés après détachement dans le cadre d'un transfert d'une couche issue d'un substrat donneur collé avec un substrat receveur pour une couche d'oxyde de 250 Å, le collage ayant été réalisé à l'issue d'une activation plasma lors duquel:
   - le substrat donneur, oxydé en surface, a été activé par un plasma de l'un de deux types de plasma sous une atmosphère neutre (azote ou argon), ou par un plasma oxydant, ou n'a pas été activé
   - et le substrat receveur en silicium non oxydé, n'a pas été activé.

Comme dans le cas de certains procédés connus, l'invention fait intervenir l'activation des deux surfaces de substrats à coller par un plasma.

Dans le cas de l'invention, on met en oeuvre une activation plasma spécifique de la surface à coller de chaque substrat, la surface à coller de seulement un premier des deux substrats étant constituée d'une couche d'oxyde. L'activation plasma de ladite couche d'oxyde est réalisée sous une atmosphère contenant de l'oxygène, et l'activation plasma de la surface à coller du deuxième substrat est réalisée sous une atmosphère inerte.

La description qui suit illustre des exemples de procédés de collage qui s'appliquent dans le cadre d'un transfert de couche d'un substrat donneur vers un substrat receveur, la couche étant détachée selon un procédé de type Smart Cut™. Cependant, l'invention se comprend comme concernant l'étape de collage en elle-même et le transfert de couche n'en est qu'une illustration particulière.

### Traitement du substrat receveur

De manière générale, les valeurs de puissance précisées dans la description qui va suivre sont données pour des applications à des plaques d'un diamètre de l'ordre de 200 mm. Toutefois, la présente invention s'applique également à des plaques d'un diamètre de l'ordre de 300 mm, en adaptant la puissance du plasma (ou les valeurs de densité de puissance).

Ainsi, d'une manière générale, la densité de puissance est comprise entre 0.035 W/cm² et 10 W/cm², de préférence 0.4 W/cm² pour l'argon, et 0.8 W/cm² pour l'azote, et 0.8 W/cm² pour l'oxygène.

La surface du substrat receveur n'est pas constituée d'une couche d'oxyde, et est de préférence en Silicium.

Préalablement à l'activation plasma, la surface à coller du substrat peut avoir été nettoyée, par exemple avec de l'ozone et/ou un mélange de RCA.

On soumet ensuite la surface du substrat receveur à une activation plasma sous une atmosphère neutre, par exemple contenant de l'argon ou de l'azote, dans les conditions expérimentales spécifiques suivantes :
Pour un traitement sous une atmosphère contenant de l'argon :
   - la puissance est comprise entre 25 et 2500 W, de préférence, elle est de 125 W pour une plaque de 200 mm ou d'environ 200 W pour une plaque de 300 mm (correspondant à une densité de puissance de 0.4 W/cm²),
   - la pression est comprise entre 20 mTorr et 100 mTorr, de préférence elle est de 50 mTorr,
   - le débit du gaz est compris entre 0 et 100 sccm, de préférence, il est de 100 sccm,
   - la durée d'exposition est comprise entre 5 s et 5 mn, de préférence, elle est de 30 s.

Pour un traitement sous une atmosphère contenant de l'azote:
- la puissance est comprise entre 25 et 2500 W, de préférence, elle est de 250 W (correspondant à une densité de puissance de 0.8 W/cm²),
- la pression est comprise entre 20 mTorr et 100 mTorr, de préférence elle est de 50 mTorr,
- le débit du gaz est compris entre 0 et 100 sccm, de préférence, il est de 100 sccm,
- la durée d'exposition est comprise entre 5 s et 5 mn, de préférence, elle est de 30 s.

Lors de l'activation plasma, la densité de puissance alimentant le plasma est adaptée au gaz utilisé. En effet, les atomes d'argon étant plus gros que les atomes d'azote, la puissance retenue pour mettre en oeuvre un plasma d'argon sera plus limitée que pour un plasma d'azote, afin d'éviter un effet de pulvérisation de l'argon.

### Traitement de la surface à coller du substrat donneur

La surface à coller du substrat donneur est constituée d'une couche d'oxyde fine, de l'ordre de 100 Å à 5000 Å d'épaisseur, de préférence inférieure à 250 Å d'épaisseur (notamment dans le cas d'une couche très fine destinée à constituer une structure de type UTBOX).

Préalablement à l'activation plasma, la surface à coller du substrat peut avoir été nettoyée, par exemple avec de l'ozone et/ou un mélange de RCA.

Le traitement par activation plasma est réalisé à l'aide du gaz oxygène selon les conditions expérimentales suivantes :
- la puissance est comprise entre 25 et 2500 W, de préférence, elle est de 250 W,
- la pression est comprise entre 20 mTorr et 100 mTorr, de préférence elle est de 50 mTorr,
- le débit du gaz est compris entre 0 et 100 sccm, de préférence, il est de 75 sccm,
- la durée d'exposition est comprise entre 5 s et 5 mn, de préférence, elle est de 30 à 45 s.

### Etape de collage des deux plaques

Les deux plaques sont mises en contact puis soumises à un traitement thermique à basse température (entre 25°C et 1100°C) de préférence entre 200°C et 600°C, en vue de renforcer l'énergie de collage, pendant une durée allant de 30 mn à 5 h, la durée d'exposition étant de préférence de 2 h.

Le but recherché du procédé présenté est en effet d'optimiser l'activation des surfaces des substrats à coller.

Un avantage de ce procédé réside dans la diminution, voire la disparition, des défauts (zones non transférées, picots, bulles et cloques) au sein de la couche mince pouvant être présents après transfert de cette couche sur le substrat.

Par ailleurs, une fois l'étape de collage réalisée, une étape d'amincissement du substrat donneur est menée, par exemple selon le procédé Smart Cut™, ou encore par gravure du substrat donneur.

En effet, la présente invention peut s'appliquer à la réalisation de substrats complexes (du type SOI par exemple) par un procédé de type Smart Cut™, mais également de type BESOI. Elle s'applique également à des substrats comportant des circuits intégrés qui ne pourraient pas subir de traitements thermiques à haute température et nécessiteraient ainsi un collage plasma.

### Description des figures

Les conditions expérimentales des collages effectués afin d'obtenir les résultats fournis sur les figures étaient les suivantes :
- oxydation (par exemple par voie thermique), pour obtenir une couche d'oxyde d'une épaisseur donnée sur la surface à coller du substrat donneur.
- implantation du substrat donneur avec de l'hydrogène seul (énergie 80 keV, dose 7.6 10¹⁶ atomes/cm²), au travers de la surface à coller,
- nettoyage des deux surface à coller par de l'ozone et/ou par nettoyage de type RCA ,
- activation plasma sous une atmosphère constituée d'oxygène (débit de 75 sccm, pression de 50 mTorr, densité de puissance de 250 W, durée de 30 s) de la surface à coller du substrat donneur,
- activation plasma sous une atmosphère contenant de l'argon (débit de 100 sccm, pression de 50 mTorr, densité de puissance de 125 W, durée de 30 s) ou d'azote d'argon (débit de 100 sccm, pression de 50 mTorr, densité de puissance de 250 W, durée de 30 s) de la surface à coller du substrat receveur,
- collage des deux surface à coller par adhésion moléculaire,
- recuit entre 200°C à 600°C pour stabiliser le collage.

Comme on peut le voir sur la figure 1, on détecte environ 15 défauts (zones non transférées, picots, bulles et cloques) sur la couche transférée après le procédé Smart Cut™ si le substrat receveur n'est pas activé par plasma, alors qu'on dénombre 4 défauts dans le cas d'une activation par un plasma d'argon, et aucun défaut dans le cas d'une activation par un plasma d'azote.

Le nombre de défauts est donc réduit de manière significative lorsque le substrat receveur est soumis à une activation plasma dans une atmosphère contenant un gaz inerte.

La figure 2 montre des résultats similaires. On détecte plus de 1000 défauts dans le cas où le substrat receveur n'a pas été activé par un plasma, alors qu'on ne dénombre que 300 défauts environ dans le cas d'un traitement plasma sous une atmosphère contenant de l'argon, et une trentaine de défauts dans le cas d'un traitement plasma sous une atmosphère contenant de l'azote.

La présence d'un nombre plus important de défauts dans le cas de la figure 2 est dû au fait que la couche d'oxyde a une épaisseur beaucoup plus fine que dans le cas de la figure 2. Le nombre total de défauts est toutefois significativement plus faible lorsque la surface à coller du substrat receveur a reçu auparavant un traitement par plasma sous une atmosphère neutre.

La figure 3 montre que, lorsque la surface du substrat donneur oxydée a été activée par un plasma oxydant, quelle que soit l'épaisseur de la couche d'oxyde du substrat donneur, l'énergie de collage est plus importante lorsque la surface à coller du substrat receveur a été traitée préalablement au collage par activation plasma (par un gaz neutre) que lorsqu'elle n'a pas été activée par plasma. L'effet de cette activation plasma dépend cependant de l'épaisseur de la couche, ainsi que du gaz neutre utilisé (argon ou azote).

Il n'y a toutefois pas de dégradation de l'énergie de collage pour les couches d'oxyde très fines (au contraire).

La figure 4 montre que l'activation de la surface oxydée du substrat donneur par un plasma oxydant, le substrat receveur n'ayant pas été activé, donne de meilleurs résultats en terme de défectivité en comparaison avec les traitements par un plasma d'argon et d'azote, ce qui explique le choix de l'activation par un plasma oxydant du substrat donneur.

La couche d'oxyde à la surface du substrat donneur a ici une épaisseur de 250 Å.

On dénombre en effet une dizaine de défauts lorsque la surface oxydée du substrat donneur a été activée par un plasma oxydant, de l'ordre d'une quinzaine de défauts, lorsque la surface oxydée du substrat donneur a été activée par un plasma sous une atmosphère comprenant de l'azote, et de l'ordre de 25 défauts lorsque la surface oxydée du substrat donneur a été activée par un plasma sous une atmosphère comprenant de l'argon.

Les résultats obtenus suite à l'activation de la surface oxydée du substrat donneur par un plasma oxydant sont par ailleurs également meilleurs en termes de défectivité que ceux obtenus lorsque la surface n'a pas été préalablement activée.

Les conditions expérimentales de réalisation du procédé décrit dans l'invention sont données à titre d'exemple non limitatif.

## Revendications

1. Procédé de collage de deux substrats réalisés dans des matériaux choisis parmi les matériaux semi-conducteurs, ledit procédé mettant en oeuvre :
• une étape de collage des deux substrats par traitement thermique,
• une activation plasma de la surface à coller de chaque substrat, la surface à coller de seulement un premier des deux substrats étant constituée d'une couche d'oxyde,
procédé **caractérisé en ce que** l'activation plasma de ladite couche d'oxyde est réalisée sous une atmosphère contenant de l'oxygène, et l'activation plasma de la surface à coller du deuxième substrat est réalisée sous une atmosphère inerte.

2. Procédé de collage selon la revendication 1, **caractérisé en ce que** le substrat dont la surface est constituée d'une couche d'oxyde est le substrat donneur pour un transfert de couche vers un substrat receveur.

3. Procédé selon la revendication 2, **caractérisé en ce que** la couche d'oxyde est obtenue par oxydation par voie thermique du substrat donneur.

4. Procédé selon la revendication 2, **caractérisé en ce que** la couche d'oxyde est déposée sur le substrat donneur.

5. Procédé selon l'une, des trois revendications précédentes, **caractérisé en ce que** le transfert permet d'obtenir une structure de type SOI (Siicon On Insulator, c'est-à-dire silicium sur isolant).

6. Procédé selon la revendication précédente, **caractérisé en ce que** ledit SOI comporte une couche mince de type « couche très fine enterrée » UTBOX (Ultra Thin Buried oxyde), dont l'épaisseur est inférieure à 500 Å.

7. Procédé selon l'une des cinq revendications précédentes, **caractérisé en ce que** le substrat receveur est en silicium.

8. Procédé selon l'une quelconque des revendications précédentes, **caractérisé en ce que** le gaz neutre est de l'argon.

9. Procédé selon la revendication précédente, **caractérisé en ce que** la densité de puissance lors de l'activation par plasma est de 0.4 W / cm².

10. Procédé selon l'une quelconque des revendications 1 à 7, **caractérisé en ce que** le gaz neutre est de l'azote.

11. Procédé selon la revendication précédente, **caractérisé en ce que** la densité de puissance lors de l'activation par plasma est de 0.8 W / cm².

12. Procédé selon l'une quelconque des revendications précédentes, en combinaison avec la revendication 2, **caractérisé en ce que** le substrat receveur est soumis à une étape de nettoyage avant l'étape d'activation par plasma.

13. Procédé selon l'une quelconque des revendications précédentes, en combinaison avec la revendication 2, **caractérisé en ce que** le substrat donneur est soumis à une étape de nettoyage avant l'étape d'activation par plasma.

14. Procédé selon l'une quelconque des revendications précédentes, **caractérisé en ce que** le traitement thermique de collage est effectué à basse température.

15. Procédé selon l'une quelconque des revendications précédentes, **caractérisé en ce que** le traitement thermique de collage est effectué entre 200°C et 600°C.

16. Procédé selon l'une quelconque des revendications précédentes, **caractérisé en ce que** le traitement thermique de collage est effectué sur une durée courte.

17. Procédé selon l'une quelconque des revendications précédentes, **caractérisé en ce que** le traitement thermique de collage est effectué pendant environ 2 heures.

## Claims

1. A method for bonding two substrates made in materials selected from semiconducting materials, said method applying:
- a step for bonding two substrates by a heat treatment,
- plasma activation of the surface to be bonded of each substrate, the surface to be bonded of only a first of the two substrates consisting of an oxide layer,
a method **characterized in that** the plasma activation of said oxide layer is achieved under an atmosphere containing oxygen, and the plasma activation of the surface to be bonded of the second substrate is achieved under an inert atmosphere.

2. The bonding method according to claim 1, **characterized in that** the substrate, the surface of which consists of an oxide layer, is the donor substrate for a layer transfer towards a receiving substrate.

3. The method according to claim 2, **characterized in that** the oxide layer is obtained by oxidation of the donor substrate via a thermal route.

4. The method according to claim 2, **characterized in that** the oxide layer is deposited on the donor substrate.

5. The method according to any of the three preceding claims, **characterized in that** with the transfer it is possible to obtain an SOI (Silicon On Insulator) type structure.

6. The method according to the preceding claim, **characterized in that** said SOI includes a thin layer of the UTBOX (Ultra Thin Buried OXide) type, the thickness of which is less than 500 Å.

7. The method according to any of the five preceding claims, **characterized in that** the receiving substrate is in silicon.

8. The method according to any of the preceding claims, **characterized in that** the neutral gas is argon.

9. The method according to the preceding claim, **characterized in that** the power density during plasma activation is 0.4 W/cm².

10. The method according to any of claims 1 to 7, **characterized in that** the neutral gas is nitrogen.

11. The method according to the preceding claim, **characterized in that** the power density during plasma activation is 0.8 W/cm².

12. The method according to any of the preceding claims in combination with claim 2, **characterized in that** the receiving substrate is subject to a cleaning step before the plasma activation step.

13. The method according to any of the preceding claims in combination with claim 2, **characterized in that** the donor substrate is subject to a cleaning step before the plasma activation step.

14. The method according to any of the preceding claims, **characterized in that** the thermal bonding treatment is carried out at low temperature.

15. The method according to any of the preceding claims, **characterized in that** the thermal bonding treatment is carried out between 200°C and 600°C.

16. The method according to any of the preceding claims, **characterized in that** the thermal bonding treatment is carried out over a short duration.

17. The method according to any of the preceding claims, **characterized in that** the thermal bonding treatment is carried out for about 2 hours.

## Patentansprüche

1. Verfahren zum Kleben von zwei Substraten, die aus Materialien hergestellt sind, die aus den Halbleitermaterialien ausgewählt sind, wobei das Verfahren einsetzt:
• einen Schritt des Klebens der beiden Substrate durch Wärmebehandlung,
• eine Plasmaaktivierung der zu klebenden Oberfläche jedes Substrats, wobei die zu klebende Oberfläche von nur einem ersten der beiden Substrate aus einer Oxidschicht gebildet ist,
wobei das Verfahren **dadurch gekennzeichnet ist, dass** die Plasmaaktivierung der Oxidschicht unter einer Sauerstoff enthaltenden Atmosphäre realisiert wird, und die Plasmaaktivierung der zu klebenden Oberfläche des zweiten Substrats unter einer inerten Atmosphäre realisiert wird.

2. Klebeverfahren gemäß Anspruch 1, **dadurch gekennzeichnet, dass** das Substrat, dessen Oberfläche aus einer Oxidschicht gebildet ist, das Gebersubstrat für einen Schichttransfer zu einem Empfängersubstrat ist.

3. Verfahren gemäß Anspruch 2, **dadurch gekennzeichnet, dass** die Oxidschicht durch thermische Oxidation des Gebersubstrats erhalten wird.

4. Verfahren gemäß Anspruch 2, **dadurch gekennzeichnet, dass** die Oxidschicht auf dem Gebersubstrat abgelegt wird.

5. Verfahren gemäß einem der drei vorhergehenden Ansprüche, **dadurch gekennzeichnet, dass** der Transfer zulässt, eine Struktur vom SOI-Typ (Silicon On Insulator, das heißt Silizium auf Isolator) zu erhalten.

6. Verfahren gemäß dem vorhergehenden Anspruch, **dadurch gekennzeichnet, das** das SOI eine Dünnschicht vom Typ "sehr dünne verdeckte Schicht" UTBOX (Ultra Thin Buried oxyde) umfasst, deren Dicke kleiner als 500Ǻ ist.

7. Verfahren gemäß einem der fünf vorhergehenden Ansprüche, **dadurch gekennzeichnet, dass** das Empfängersubstrat aus Silizium ist.

8. Verfahren gemäß einem der vorhergehenden Ansprüche, **dadurch gekennzeichnet, dass** das neutrale Gas Argon ist.

9. Verfahren gemäß dem vorhergehenden Anspruch, **dadurch gekennzeichnet, dass** die Leistungsdichte bei der Aktivierung durch Plasma 0.4 W / cm² ist.

10. Verfahren gemäß einem der Ansprüche 1 bis 7, **dadurch gekennzeichnet, dass** das neutrale Gas Stickstoff ist.

11. Verfahren gemäß dem vorhergehenden Anspruch, **dadurch gekennzeichnet, dass** die Leistungsdichte bei der Aktivierung durch Plasma 0.8 W / cm² ist.

12. Verfahren gemäß einem der vorhergehenden Ansprüche in Kombination mit Anspruch 2, **dadurch gekennzeichnet, dass** das Empfängersubstrat einem Reinigungsschritt vor dem Schritt der Aktivierung durch Plasma unterzogen wird.

13. Verfahren gemäß einem der vorhergehenden Ansprüche in Kombination mit Anspruch 2, **dadurch gekennzeichnet, dass** das Gebersubstrat einem Reinigungsschritt vor dem Schritt der Aktivierung durch Plasma unterzogen wird.

14. Verfahren gemäß einem der vorhergehenden Ansprüche, **dadurch gekennzeichnet, dass** die Klebewärmebehandlung bei niedriger Temperatur durchgeführt wird.

15. Verfahren gemäß einem der vorhergehenden Ansprüche, **dadurch gekennzeichnet, dass** die Klebewärmebehandlung zwischen 200°C und 600°C durchgeführt wird.

16. Verfahren gemäß einem der vorhergehenden Ansprüche, **dadurch gekennzeichnet, dass** die Klebewärmebehandlung über eine kurze Dauer durchgeführt wird.

17. Verfahren gemäß einem der vorhergehenden Ansprüche, **dadurch gekennzeichnet, dass** die Klebewärmebehandlung während ungefähr 2 Stunden durchgeführt wird.
